Europäisches Patentamt

**European Patent Office**

**Office européen des brevets**

(19)

(11) Numéro de publication: **0 267 100 B1**

(12) **FASCICULE DE BREVET EUROPEEN**

(45) Date de publication de fascicule du brevet: **12.08.92**  (51) Int. Cl.5: **H03B 5/18**

(21) Numéro de dépôt: **87402385.6**

(22) Date de dépôt: **23.10.87**

(54) **Oscillateur hyperfréquence à transistor, accordable par tension et générateur hyperfréquence à large bande comportant de tels oscillateurs.**

(30) Priorité: **27.10.86 FR 8614924**

(43) Date de publication de la demande:
**11.05.88 Bulletin 88/19**

(45) Mention de la délivrance du brevet:
**12.08.92 Bulletin 92/33**

(84) Etats contractants désignés:
**DE GB IT**

(56) Documents cités:
**EP-A- 0 048 189**
**DE-A- 2 613 119**
**DE-A- 2 637 360**
**US-A- 3 444 480**
**US-A- 4 310 809**

**IEEE MTT-S INTERNATIONAL MICROWAVE SYMPOSIUM DIGEST, 27-29 juin 1978, pages 315-317, IEEE, New York, US; G.F. BOCK et aL.: "An RF linear modulation circuit"**

**INSTRUMENTS AND EXPERIMENTAL TECHNI-OUES, vol. 27, no. 1, janvier-février 1984, pages 143-144, Plenum Publishing CORP., New York, US; S.S. BONDARENKO et al.: "Transistor oscillator with a dielectric reso-**
nator"

(73) Titulaire: **THOMSON-CSF**
**51, Esplanade du Général de Gaulle**
**F-92800 Puteaux(FR)**

(72) Inventeur: **Riboni, Raymond**
**THOMSON-CSF SCPI 19, avenue de Messine**
**F-75008 Paris(FR)**

(74) Mandataire: **Lincot, Georges et al**
**THOMSON-CSF SCPI**
**F-92045 PARIS LA DEFENSE CEDEX 67(FR)**

## Description

La présente invention concerne un oscillateur hyperfréquence à transistor accordable par tension et un générateur hyperfréquence à large bande comportant de tels oscillateurs.

Elle s'applique à la réalisation d'oscillateurs hyperfréquences accordables par tension du type de celui décrit par exemple dans la demande de brevet allemand 2 613 119, fonctionnant dans les gammes de fréquences comprises par exemple entre 500 et 2000 MHz dans lesquels, la fréquence d'accord varie de manière continue en fonction d'une tension continue de polarisation appliquée au moins sur une diode à capacité variable d'un résonateur. Elle trouve également son application à la réalisation de synthétiseurs de fréquence.

Les méthodes de conception de tels oscillateurs sont bien connues et leurs descriptions peuvent être trouvées par exemple dans le livre intitulé "Design of amplifiers and oscillators by the S-parameters methods" de G. VENDELIN publié chez JOHN WILLEY.

Cependant, l'application de ces méthodes rencontre au plan pratique de nombreuses difficultés qui sont dues le plus souvent à une méconnaissance au moment de la conception des circuits des oscillateurs de certains paramètres physiques inhérents au câblage et à la disposition des composants des osciliateurs sur les circuits imprimés. Ces paramètres incontrôlés sont la cause d'apparition en cours de fonctionnement de raies de fréquences parasites ou encore de variations brutales du niveau du signal utile. Ces défauts apparaissent souvent lorsque les conditions de fonctionnement sont les plus critiques, notamment, à la mise sous tension, pour les températures extrêmes de fonctionnement ou encore, par exemple, lorsque les diodes à capacité variable ne sont pas polarisées.

D'autre part, des défauts de linéarité de la caractéristique fréquence-tension apparaissent lorsque pour les tensions de commande élevées la capacité de la diode à capacité variable est faible relativement aux capacités parasites du circuit inductif du résonateur. Dans ces conditions le rapport des pentes fréquences-tensions à chaque extrémité de la gamme des fréquences de fonctionnement de l'oscillateur ne peut plus être maintenu dans la norme acceptable (inférieure à 2) et les performances en bruit de phase et en temps d'acquisition des synthétiseurs utilisant ce type d'oscillateur s'en trouvent affectées.

Cette mauvaise tenue des performances se concrétise au plan industriel par des difficultés de reproduction. Elle entraîne également des difficultés d'assemblage lorsque dans certaines applications il faut, pour élargir la bande des fréquences, coupler plusieurs oscillateurs ensemble pour fractionner la bande en plusieurs sous-gammes affectées chacune à un oscillateur. En plus les problèmes de couplage entre oscillateurs rendent plus compliqué ce dernier type de réalisation.

Le but de l'invention est de pallier les inconvénients précités.

A cet effet, l'invention a pour objet, un oscillateur hyperfréquence à transistor accordable par tension comprenant :
- une plaque support en matériau diélectrique comportant une première face, métallisée au moins en partie pour former le circuit de masse fixant la référence des potentiels de l'oscillateur et possédant une deuxième face parallèle à la première face sur laquelle sont disposés les composants de l'oscillateur,
- un résonateur,
- un circuit électronique actif formé par au moins un transistor monté en collecteeur commun, couplé par sa base au résonateur pour permettre l'entretien des oscillations dans le résonateur, le transistor comprenant au moins une sortie d'émetteur reliée par l'intermédiaire d'au moins un condensateur au potentiel de masse, caractérisé en ce que l'électrode de collecteur est reliée à la partie métallisée de la première face par un trou métallisé reliant la première face a' la deuxième face, en ce que chaque condensateur est formé par une première plaque métallique déposée sur la deuxième face de la plaque support, une deuxième plaque métallique formée par la première face métallisée de la plaque support, et par un diélectrique disposé entre les deux plaques formé par le diélectrique de la plaque support, et en ce que le résonateur comprend un circuit résonnant composé par une pluralité d'inductances et une pluralité de diodes à capacité variable reliées en série, le nombre d'inductances et de diodes à capacité variable reliées en série étant au moins égal à 2.

L'invention a également pour objet, un générateur hyperfréquence à large bande comportant un tel oscillateur.

D'autres caractéristiques et avantages de l'invention apparaîtront ci-après à l'aide de la description qui suit faite en regard des dessins annexés qui représentent:
- la figure 1 un schéma de principe d'un oscillateur selon l'invention,
- la figure 2 une vue en coupe partielle d'une plaque support sur laquelle reposent les composants de l'oscillateur de la figure 1,
- la figure 3 une vue de dessus du plan d'implantation des composants de l'oscillateur sur la plaque support,
- la figure 4 un schéma d'un résonateur pouvant être utilisé pour la mise en oeuvre de l'oscillateur de la figure 1,
- la figure 5 un principe de couplage de plusieurs oscillateurs selon l'invention permettant la réalisation de générateurs hyperfréquences à large bande.

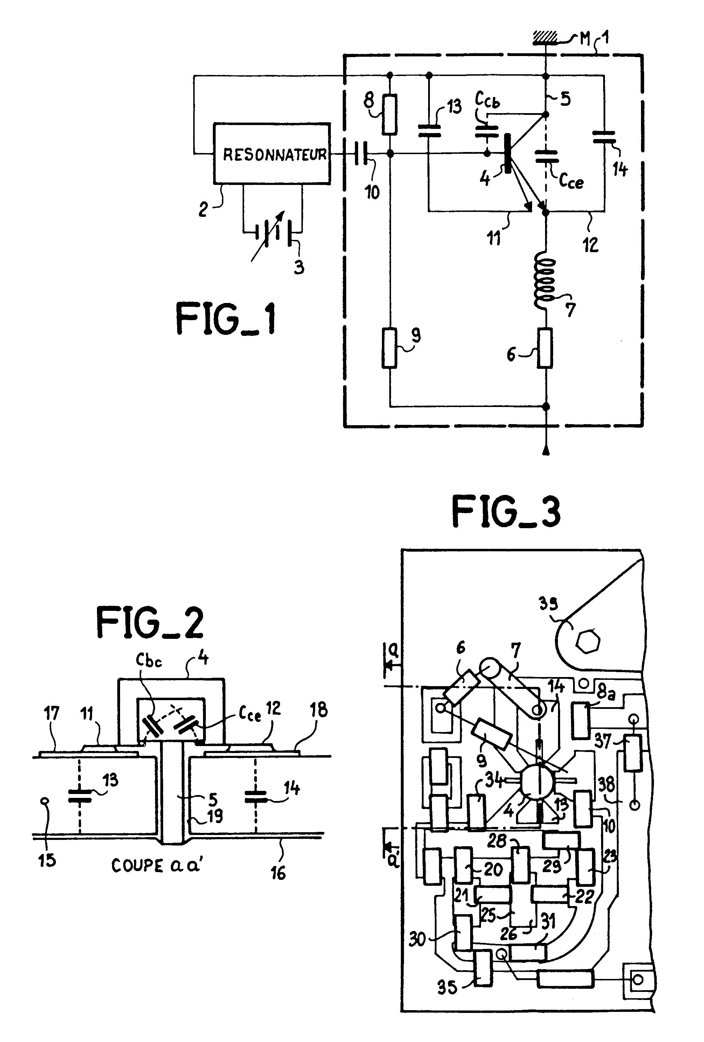

L'oscillateur commandé en tension selon l'invention qui est représenté par le schéma de principe simplifié de la figure 1, comprend un circuit électronique actif 1 et un résonateur 2. Une source variable 3 commande la fréquence d'accord du résonateur 2.

Le circuit électronique actif 1 entretient les oscillations engendrées dans le résonateur 2. Il est composé par un transistor 4, dont le collecteur est relié par une liaison conductrice 5 à un circuit de masse M et dont l'émetteur est polarisé au moyen d'une résistance 6 et d'une inductance ou self de choc 7 reliées en série entre l'émetteur et une borne d'alimentation du circuit de l'oscillateur. La borne d'alimentation est portée à un potentiel d'alimentation -U par rapport au potentiel du circuit de masse M. La base du transistor 4 est polarisée à l'aide d'un pont de polarisation formé par deux résistances 8 et 9, reliées en série entre la borne d'alimentation de potentiel -U et le circuit de masse M. Un condensateur 10 est relié en série entre la base du transistor 4 et le circuit d'accord 2. L'émetteur du transistor 4 comprend deux sorties distinctes 11 et 12 reliées respectivement au circuit de masse M au travers de deux condensateurs 13 et 14. Les condensateurs 13 et 14 constituent avec les capacités collecteur-base et collecteur-émetteur du transistor 4, respectivement désignés par les abréviations $C_{cb}$ et $C_{ce}$ sur la figure 1, le circuit de réaction de l'oscillateur.

Ainsi réalisé l'oscillateur fonctionne suivant le principe des oscillateurs à résistance négative.

L'élimination des fréquences parasites et des variations indésirables de l'amplitude du signal délivré par l'oscillateur est obtenue selon l'invention, par le choix approprié des valeurs des composants, une implantation précise de ceux-ci et par la réduction des inductances indésirables engendrées notamment par la liaison 5 et les condensateurs 13 et 14.

Un exemple de réalisation d'un oscillateur permettant de satisfaire toutes ces exigences, est montré aux figures 2 et 3 qui représentent un mode d'assemblage de ses composants sur une plaque support en matériau diélectrique 15. Sur ces figures, les éléments homologues à ceux déjà représentés à la figure 1 sont repérés avec les mêmes références. Une première face de la plaque support 15 est recouverte par une couche métallique 16, figurant le circuit de masse M de l'oscillateur. Les sorties 11 et 12 de l'émetteur du transistor 4 sont soudées à deux couches ou plaques métalliques 17 et 18 gravées sur la deuxième face de la plaque support parallèlement à la première face pour former avec le circuit de masse 16 et le diélectrique de la plaque support 15 les condensateurs 13 et 14. Le diélectrique peut éventuellement être constitué par du polytétrafluoréthylène encore dénommé PTFE et commercialisé sous la marque de fabrique TEFLON. L'avantage du téflon est qu'il possède de très faibles pertes aux hautes fréquences. Toujours suivant le mode de réalisation de la figure 2 la connexion du collecteur 5 au circuit de masse 16 est obtenue par un trou métallisé 19, percé dans l'épaisseur de la plaque support 15.

Les dimensions des surfaces des deux couches conductrices 16 et 17 déterminent avec les caractéristiques du diélectrique de la plaque support 15, la valeur des condensateurs 13 et 14. De préférence, les couches 16 et 17 sont placées le plus près possible du boîtier du transistor 4.

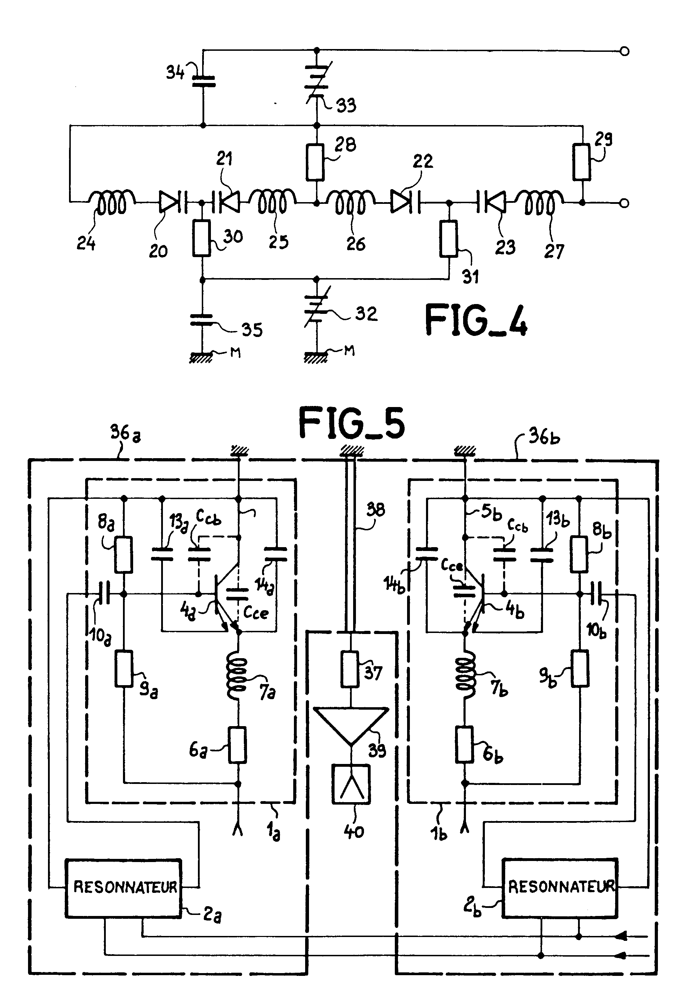

Le résonateur 2 qui est représenté à la figure 4 est équivalent à un circuit résonnant de type série dont l'inductance L est fixe et dont la capacité d'accord $C_v$ est variable. La capacité variable $C_v$ est constituée par l'association de quatre diodes à capacité variable 20, 21, 22 et 23 du type connu par exemple sous la référence BB621 et commercialisées par la société SIEMENS, reliées en série à quatre inductances 24, 25, 26 et 27. Le réglage de la fréquence d'accord du résonateur est obtenu en faisant varier les tensions appliquées aux bornes des diodes 20 à 23, au travers de résistances 28, 29, 30 et 31 au moyen de générateurs de tension continue variable 32 et 33. Les résistances 28, 29, 30 et 31 présentent aux fréquences de fonctionnement du résonateur des impédances élevées. La résistance 28 est reliée par une extrémité aux anodes des diodes 21 et 22 au travers des inductances 25 et 26 respectivement et par son autre extrémité au pôle négatif du générateur 33. Egalement la résistance 29 est reliée par une première extrémité au pôle négatif du générateur 33 et par une deuxième extrémité à l'anode de la diode 23 au travers de l'inductance 27. Pour des raisons pratiques de réalisation, le générateur 33 peut être placée à l'extérieur du circuit imprimé 15. Eventuellement ce générateur pourra délivrer par exemple, des tensions continues variables par bonds pour réaliser un prépositionnement du résonateur. Le circuit de la figure 4 comprend également deux autres résistances 30 et 31 reliées respectivement par une de leurs extrémités aux cathodes des diodes 20 et 21 et aux cathodes des diodes 22 et 23, et par leurs autres extrémités à un générateur de tension continue variable 32. Comme précédemment le générateur 32 peut être placé à l'extérieur du circuit imprimé 15. Ce type de commande dite "commande en flottant" de l'élément variable d'un résonateur accordable est connu. L'énergie réactive se développe entre le point commun à l'inductance 27 et la résistance 29, et le circuit de masse M. Le retour à la masse des courants haute fréquence s'effectue au moyen d'un condensateur 34 en un point situé le plus près possible du collecteur du transistor 4. Ainsi le résonateur occupe une surface minimale ce qui contribue à réduire le risque de couplage indésirable. Un condensateur 35 découple le générateur 32.

Contrairement aux réalisations connues où l'inductance d'accord du résonateur comprend un seul élément et où il existe toujours une capacité parasite entre les bornes de l'inductance d'accord et entre chaque point de cette inductance et le circuit de métallisation M, l'inductance d'accord est sur la figure 4 composée de quatre inductances 24 à 27 reliées en série au travers des diodes 20 à 23. Chaque inductance est réalisée sur la plaque support par une connexion conductrice déposée sur la deuxième face, la partie en regard sur la première face n'étant pas métallisée comme cela est représenté sur la figure 3. En découpant ainsi l'inductance en 4 inductances de valeurs L/4 on augmente dans le rapport 2 la fréquence propre de l'accord parallèle indésirable et d'autre part, on diminue la capacité parasite consécutive à la réduction de la surface de chaque tronçon d'inductance. Plus généralement avec un découpage de l'inductance en N inductances de valeurs L/N on pourra obtenir selon d'autres réalisations une augmentation dans le rapport $N^{\frac{1}{2}}$ de la fréquence propre de l'accord parallèle indésirable. De ce fait, l'écart entre l'accord parallèle indésirable et l'accord série utile est augmenté; et par suite, l'influence de impédance capacitive parasite est diminuée ce qui améliore la linéarité de la courbe fréquence-tension de l'oscillateur, et le rapport de leurs pentes extrêmes fréquences-tensions. A titre d'exemple, un rapport de 1,27 correspondant à des valeurs de pentes extrêmes égales à 33 MHz/volt et 42 MHz/volt peut être obtenu, alors que sans les précautions précitées le rapport obtenu n'est que de 4,5 pour des valeurs extrêmes de pentes égales à 10 MHz/volt et 45 MHz/volt. Un autre avantage procuré par ces résultats et que l'on peut sans utiliser de réseau correcteur à l'entrée de commande en fréquence du résonateur, obtenir une constance suffisante de la fonction de transfert de la boucle d'asservissement de phase des synthétiseurs de fréquence dont l'oscillateur selon l'invention est un des éléments. L'intérêt est que l'on obtient une constance des performances des synthétiseurs conçus suivant ce principe, qui se concrétise par une stabilité du temps d'acquisition en saut de fréquence entre deux fréquences et par des variations peu importantes de la densité spectrale du bruit de phase.

Un schéma de principe permettant de coupler deux oscillateurs $36_a$ et $36_b$ selon l'invention sur une plaque support pour obtenir un générateur hyperfréquence à large bande est représenté à la figure 5. Suivant ce mode de réalisation les tensions de commande des deux résonateurs $2_a$ et $2_b$ sont appliquées en permanence par un générateur de tension extérieur, non représenté. Un commutateur extérieur également non représenté applique la tension d'alimentation -U soit à l'oscillateur $36_a$ soit à l'oscillateur $36_b$. Une résistance de charge 37 est implantée à peu près à égale distance des circuits émetteurs $6_a$ , $7_a$ d'une part, et $6_b$ et $7_a$ d'autre part, des transistors $4_a$ et $4_b$ de chacun des oscillateurs. De ce fait l'indice que présente le couplage entre la résistance de charge 37 et les émetteurs des transistors 4 de chacun des oscillateurs est sensiblement le même; l'énergie prélevée est alors identique quelque soit l'oscillateur alimenté. En fait, l'un des transistors $4_a$ ou $4_b$ lorsqu'il n'est pas alimenté, se comporte comme une impédance élevée et l'énergie prélevée par les éléments actifs non alimentés est faible. Un écran électrostatique 38 constitué par exemple par une ligne métallisée déposée sur la deuxième face de la plaque support et de la façon représentée à la figure 3 élimine le couplage résiduel entre les deux oscillateurs dont les circuits sont imbriqués autour de la charge 37. Un amplificateur 39 en circuit intégré du type par exemple de celui désigné sous la référence CGY31 commercialisé par la société SIEMENS, suivi d'un répartiteur 40 à deux voies délivre, deux signaux haute fréquence. Cet amplificateur dont le gain inverse est élevé permet d'isoler chaque oscillateur des variations du taux d'onde stationnaire de l'une quelconque des charges de sortie. Naturellement ce principe peut encore s'appliquer au couplage de plus de deux oscillateurs sur une même plaque support.

**Revendications**

1.  Oscillateur hyperfréquence à transistor, accordable par tension, comprenant :
    -   une plaque support en matériau diélectrique (15) comportant une première face, métallisée au moins en partie pour former le circuit de masse (16) fixant la référence des potentiels de l'oscillateur et possédant une deuxième face parallèle à la première face sur laquelle sont disposés les composants de l'oscillateur,
    -   un résonateur (2),
    -   un circuit électronique actif (1) formé par au moins un transistor (4) monté en collecteur commun, couplé par sa base au résonateur (2) pour permettre l'entretien des oscillations dans le résonateur, le transistor (4) comprenant au moins une sortie d'émetteur reliée par l'intermédiaire d'au moins un condensateur (13, 14) au potentiel de masse, caractérisé en ce que l'électrode de collecteur est reliée à la partie métallisée (16) de la première face par un trou métallisé (19) reliant la première face à la deuxième face, en ce que chaque condensateur (13, 14) est formé par une première plaque métallique (17, 18) déposée sur la deuxième face de la plaque support, une deuxième plaque métallique formée par la première face métallisée (16) de la plaque support, et par un diélectrique disposé entre les deux plaques formé par le diélectrique (15) de la plaque support, et en ce que le résonateur comprend un circuit résonnant composé par une pluralité d'inductances (24, 25, 26, 27) et une pluralité de diodes (20, 21, 22, 23) à capacité variable reliées en série, le nombre d'inductances et de diodes à capacité variable reliées en série étant au moins égal à 2.

2. Oscillateur selon la revendication 1, caractérisé en ce que l'émetteur du transistor (4) comprend deux sorties reliées respectivement au circuit de masse (16) par l'intermédiaire d'un condensateur (13, 14).

3. Oscillateur selon les revendications 1 à 2, caractérisé en ce que le matériau diélectrique de la plaque support (15) est du polytétrafluoréthylène.

4. Oscillateur selon l'une quelconque des revendications 1 à 3, caractérisé en ce que les inductances (24, 25, 26, 27) sont réalisées sur la plaque support par des connexions conductrices déposées sur la deuxième face la plaque support, les parties en regard sur la première face de ces connexions n'étant pas métallisées.

5. Générateur hyperfréquence à large bande, caractérisé en ce qu'il comprend une pluralité d'oscillateurs (36$_a$, 36$_b$) selon l'une quelconque des revendications 1 à 4 , montés en série sur une même plaque support (15) fonctionnant chacun dans une sous-gamme de la bande de fréquence du générateur.

6. Générateur selon la revendication 5, caractérisé en ce qu'au cours de fonctionnement sur une fréquence déterminée seul l'oscillateur pouvant délivrer cette fréquence est alimenté.

7. Générateur selon les revendications 5 et 6, caractérisé en ce que les oscillateurs (36$_a$, 36$_b$)

alimentent alternativement une même charge commune (37).

8. Générateur selon l'une quelconque des revendications 5 à 7, caractérisé en ce qu'il comprend un écran électrostatique (38) formé par une bande métallique déposée sur la deuxième face de la plaque support pour éliminer les couplages résiduels entre oscillateurs.

9. Utilisation du générateur selon l'une quelconque des revendications 5 à 8 à la réalisation de synthétiseurs de fréquence.

## Claims

1. Hyperfrequency transistor oscillator, tunable by voltage, comprising:
   - a mounting plate made of a dielectric material (15) comprising a first face, at least partly metal-coated in order to form the earthing circuit (16) establishing the reference for the oscillator potentials and with a second face parallel to the first face on which the components of the oscillator are arranged,
   - a resonator (2),
   - an active electronic circuit (1) formed by at least one transistor (4) assembled as a common collector, coupled at its base to the resonator (2) in order to enable the oscillations to be sustained within the resonator, the transistor (4) comprising at least one emitter output connected via at least one capacitor (13, 14) to the earth potential, characterised in that the collector electrode is connected to the metal-coated part (16) of the first face by a metal-coated through-hole (19) connecting the first face to the second face, that each capacitor (13, 14) is formed by a first metal plate (17,18) placed on the second face of the mounting plate, a second metal plate formed by the first metal-coated face (16) of the mounting plate, and by a dielectric arranged between the two plates formed by the dielectric (15) of the mounting plate, and that the resonator comprises a resonant circuit made up of a number of inductors (24, 25, 26, 27) and a number of variable capacitance diodes (20, 21, 22, 23) connected in series, the number of inductors and variable capacitance diodes connected in series being at least equal to 2.

2. Oscillator according to claim 1, characterised in that the emitter of the transistor (4) comprises two outputs, connected respectively to the earthing circuit (16) via a capacitor (13, 14).

3. Oscillator according to claims 1 to 2, characterised in that the dielectric material of the mounting plate (15) is polytetrafluoroethylene.

4. Oscillator according to any one of claims 1 to 3, characterised in that the inductors (24, 25, 26, 27) are produced on the mounting plate by means of conductive connections disposed on the second face of the mounting plate, the parts of said connections facing the second face being not metal-coated.

5. Broad-band hyperfrequency generator, characterised in that it comprises a number of oscillators ($36_a$, $36_b$) according to any one of claims 1 to 4, mounted in series on the same mounting plate (15), each operating in a subrange of the frequency band of the generator.

6. Generator according to claim 5, characterised in that whilst operating at a specific frequency, power is supplied only to the oscillator able to generate said frequency.

7. Generator according to claims 5 and 6, characterised in that the oscillators ($36_a$, $36_b$) alternately supply the same common load (37).

8. Generator according to one of claims 5 to 7, characterised in that it comprises an electrostatic shield (38) formed by a metal strip placed on the second face of the mounting plate in order to eliminate residual couplings between oscillators.

9. Application of the generator according to one of claims 5 to 8 for the manufacture of frequency synthesizers.

**Patentansprüche**

1. Spannungsabstimmbarer Transistor-Höchstfrequenzoszillator mit:
   - einer Trägerplatte aus einem dielektrischen Material (15) mit einer ersten Fläche, die zumindest teilweise metallisiert ist, um eine Masseschaltung (16) zu bilden, die das Bezugspotential des Oszillators bildet, und mit einer zweiten zur ersten Fläche parallelen Fläche, auf der die Komponenten des Oszillators angeordnet sind,
   - einem Resonator (2),
   - einer aktiven elektronischen Schaltung (1), die durch mindestens einen Transistor (4) in Kollektorschaltung gebildet ist, der mit seiner Basis an den Resonator (2) angeschlossen ist, um das Aufrechterhalten von Schwingungen im Resonator zu ermöglichen, wobei der Transistor (4) mindestens einen Emitterausgang aufweist, der über mindestens einen Kondensator (13, 14) mit dem Massepotential verbunden ist, dadurch gekennzeichnet, daß die Kollektorelektrode mit dem metallisierten Teil (16) auf der ersten Fläche durch ein metallisiertes Loch (19) verbunden ist, das die erste Fläche mit der zweiten Fläche verbindet, daS jeder Kondensator (13, 14) durch mindestens einen metallischen Belag (17, 18) gebildet ist, der auf der zweiten Fläche der Trägerplatte ausgebildet ist, einen zweiten metallischen Belag, der durch die erste metallisierte Fläche (16) der Trägerplatte gebildet ist, und durch das zwischen den beiden Belägen liegende Dielektrikum gebildet ist, das durch das Dielektrikum (15) der Trägerplatte gebildet wird, und daß der Resonator eine Resonanzschaltung aufweist, die aus mehreren Induktivitäten (24, 25, 26, 27) und mehreren mit diesen in Reihe geschalteten variablen Kapazitätsdioden (20, 21, 22, 23) gebildet ist, wobei die Anzahl von Induktivitäten und mit diesen in Reihe geschalteten variablen Kapazitätsdioden mindestens 2 ist.

2. Oszillator nach Anspruch 1, dadurch gekennzeichnet, daß der Emitter des Transistors (2) zwei Ausgänge aufweist, die jeweils über einen Kondensator (13, 14) mit der Masseschaltung (16) verbunden sind.

3. Oszillator nach den Ansprüchen 1 bis 2, dadurch gekennzeichnet, daß das dielektrische Material der Trägerplatte (15) aus Polytetrafluorethylen besteht.

4. Oszillator nach einem der Ansprüche 1 bis 3, dadurch gekennzeichnet, daß die Induktivitäten (24, 25, 26, 27) auf der Trägerplatte durch leitende Verbindungen gebildet werden, die auf der zweiten Fläche der Trägerplatte ausgebildet sind, wobei der ersten Fläche gegenüberstehende Teile dieser Verbindungen nicht metallisiert sind.

5. Breitbandiger Höchstfrequenzgenerator, dadurch gekennzeichnet, daß er mehrere Oszillatoren (36a, 36b) nach einem der Ansprüche 1 bis 4 aufweist, die in Reihe auf derselben Trägerplatte (15) angebracht sind, wobei jede in einem Unterbereich des Frequenzbandes des Generators arbeitet.

6. Generator nach Anspruch 5, dadurch gekennzeichnet, daß beim Betreiben mit einer einzigen vorgegebenen Frequenz derjenige Oszillator, der diese Frequenz liefern kann, mit Energie versorgt wird.

7. Generator nach den Ansprüchen 5 und 6, dadurch gekennzeichnet, daß die Oszillatoren (36a, 36b) abwechselnd eine gemeinsame Last (37) versorgen.

8. Generator nach einem der Ansprüche 5 bis 7, dadurch gekennzeichnet, daß er einen elektrostatischen Schirm (38) aufweist, der durch ein metallisches Band gebildet wird, das auf der zweiten Fläche der Trägerplatte ausgebildet ist, um Restkopplungen zwischen Oszillatoren auszuschließen.

9. Verwendung eines Generators nach einem der Ansprüche 5 bis 8 zum Realisieren von Frequenzsynthesizern.

**FIG_1**

**FIG_2**

COUPE a a'

**FIG_3**

FIG_4

FIG_5